# EUROPÄISCHE PATENTSCHRIFT

(11) **EP 2 338 034 B1**
(45) Veröffentlichungstag und Bekanntmachung des Hinweises auf die Patenterteilung: **14.12.2016**
(21) Anmeldenummer: 09783642.3
(22) Anmeldetag: 01.10.2009
(51) Int. Cl.: B29C 33/12, G01P 1/02, B29C 45/16, G01D 11/24, B29C 45/14

(54) **SENSORELEMENT UND TRÄGERELEMENT ZUR HERSTELLUNG EINES SENSORS**
SENSOR ELEMENT AND SUPPORT ELEMENT FOR MANUFACTURING A SENSOR
ÉLÉMENT CAPTEUR ET ÉLÉMENT SUPPORT POUR FABRIQUER UN CAPTEUR

(30) Priorität: 02.10.2008 DE 102008049958; 19.12.2008 DE 102008064047
(43) Veröffentlichungstag der Anmeldung: 29.06.2011
(73) Patentinhaber: Continental Teves AG & Co. oHG, 60488 Frankfurt (DE)
(72) Erfinder: DE VOLDER, Edmond, B-9100 Sint-Niklaas (BE); HUBER, Dietmar, 63128 Dietzenbach (DE); DÖRING, Andreas, 65207 Wiesbaden (DE); SCHILLINGER, Jakob, 8508 Gaimersheim (DE); WATZLAWIK, Martin, 63477 Maintal (DE); BIEBRICHER, Lothar, 61440 Oberursel (DE)
(86) Internationale Anmeldenummer: PCT/EP2009/062752
(87) Internationale Veröffentlichungsnummer: WO 2010/037812

(56) Entgegenhaltungen:
- EP-A2- 1 262 779
- EP-A2- 1 811 566
- WO-A2-2008/113336
- DE-A1- 4 111 568
- DE-A1- 10 333 035
- DE-A1- 10 333 197
- DE-A1-102004 060 297
- DE-A1-102004 062 087
- DE-A1-102007 037 910
- DE-U1-202007 002 582
- FR-A1- 2 864 700
- JP-A- 2000 108 205
- JP-A- 2000 206 130
- US-A1- 2003 033 875
- US-A1- 2004 080 314
- US-A1- 2005 115 317
- US-A1- 2005 179 557
- US-A1- 2005 275 141
- AMESOEDER S ET AL: "PLASMA SORGT FUER FESTEN VERBUND" KUNSTSTOFFE, CARL HANSER VERLAG, MUNCHEN, DE, Bd. 93, Nr. 9, 1. Januar 2003 (2003-01-01) , Seiten 124-129, XP001171704 ISSN: 0023-5563

## Beschreibung

Die Erfindung betrifft ein Sensorelement, ein Trägerelement zur Aufnahme eines Sensorelements, ein Verfahren zur Herstellung eines Sensors, sowie die Verwendung des Sensorelement und des Trägerelements in Kraftfahrzeugen.

Druckschrift WO 95/17680 schlägt einen Raddrehzahlsensor mit einem Leadframe vor, der beidseitig bestückt ist und ein Gehäuse mit einem Messfühlerelement und einer elektronischen Schaltung, angeordnet auf einer Seite des Leadframes, und einem Magneten, angeordnet auf der anderen Seite des Leadframes, aufweist.

In Druckschrift WO 97/36729 wird ein Verfahren zur Herstellung eines Raddrehzahlsensors vorgeschlagen, welcher ein erstes Gehäuseteil umfasst, das Positionierelemente mit integrierten Schmelzrippen aufweist, wobei dieses erste Gehäuseteil in einem Kunststoffspritzvorgang von einem zweiten Gehäuseteil umgeben wird.

Die Erfindung hat sich die Aufgabe gestellt, eine einfache Herstellung eines Sensors zu ermöglichen, der insbesondere besonders dicht und maßhaltig ausgebildet ist.

Diese Aufgabe wird erfindungsgemäß gelöst durch das Sensorelement gemäß Anspruch 1, das Trägerelement gemäß Anspruch 7 sowie durch das Verfahren zur Herstellung eines Sensors gemäß Anspruch 11.

Das Sensorelement umfasst vorzugsweise ein erstes Gehäuse, welches mit einem Basiselement verbunden ist.

Unter einem Basiselement wird bevorzugt ein Leadframe und/oder ein Strukturelement des Sensorelements und/oder ein Trägerstreifen/eine Trägerfolie oder ein MID-Element (Molded Interconnect Device), (spritzgegossener Schaltungsträger), welches einen Kunststoffkörper bzw. einen Spitzgusskörper umfasst, der auf diesen aufgebrachte und/oder von diesem umschlossene Leiterbahnen aufweist, die beispielsweise aus Metall und/oder einem leitfähigen Kunststoff ausgebildet sind, verstanden.

Die Haltevorrichtung ist vorzugsweise von außen umgreifbar ausgebildet.

Die Haltevorrichtung weist bevorzugt eine, insbesondere abgerundete, umgreifbare Kante auf.

Es ist bevorzugt, dass wenigstens eine Haltevorrichtung, insbesondere die Haltevorrichtung des ersten Gehäuses, zumindest eine Fixiernase oder Fixierkante aufweist, besonders bevorzugt mindestens eine Fixiernase oder Fixierkante auf jeweils zwei gegenüberliegenden Außenflächen des entsprechenden Gehäuses, ganz besonders bevorzugt jeweils zwei von einander beabstandete Fixiernasen auf jeweils zwei gegenüberliegenden Außenflächen des entsprechenden Gehäuses.

Die Haltevorrichtung ist vorzugsweise Teil eines ersten Gehäuses und mit diesem einstückig verbunden, wobei das erste Gehäuse direkt oder indirekt mit dem Basiselement verbunden ist.

Das erste Gehäuse umfasst bevorzugt wenigstens das Messfühlerelement und/oder eine elektronische Signalverarbeitungsschaltung.

Es ist zweckmäßig, dass das Sensorelement zusätzlich ein zweites Gehäuse aufweist, welches ebenfalls eine von außen umgreifbare Haltevorrichtung umfasst. Das zweite Gehäuse besteht insbesondere aus Kunststoff, beispielsweise aus Epoxy, und umschließt einen Teil des Leadframes bzw. Trägerstreifens bzw. Basiselements. Besonders bevorzugt umschließt das zweite Gehäuse ein elektronisches Schutzelement, wie beispielsweise einen Kondensator oder eine Zenerdiode oder einen Varistor, welches mit dem Basiselement elektrisch verbunden ist. Ein Vorteil des zweiten Gehäuses ist in einer mechanischen Kraftentkopplung der elektrischen Kontaktierungen bzw. Bonddrähte, insbesondere des Messfühlerelements und der Signalverarbeitungsschaltung, mit dem Basiselements zu sehen. Kräfte entstehen während der Verarbeitung des Sensorelementes beim Biegen, Einclipsen, Kontaktieren. Außerdem ermöglicht das zweite Gehäuse des Sensorelements eine genauere Positionierung des Sensorelementes in das Trägerelement durch die zweite Einclipsstelle sowie eine positionsgerechtere Fixierung des Sensorelements in dem Trägerelement während des späteren gemeinsamen Umspritzens.

Das erste und/oder das zweite Gehäuse des Sensorelements weisen vorzugsweise auf jeweils zwei gegenüberliegenden Außenflächen jeweils wenigstens eine Haltevorrichtung auf. Diese Haltevorrichtungen ragen jeweils insbesondere axial bezüglich des Basiselements vom Gehäuse ab.

Das erste und/oder zweite Gehäuse des Sensorelements ist bevorzugt aus Kunststoff, insbesondere aus Epoxy ausgebildet.

Das Basiselement bzw. der Leadframe des Sensorelements weist zweckmäßigerweise Kontaktierungsbeine auf, mittels welcher das Sensorelement und/oder der Sensor elektrisch mit einem externen System verbindbar sind.

Das Trägerelement wird vorzugsweise weitergebildet, indem dieses zumindest teilweise aus Kunststoff, besonders bevorzugt aus Thermoplast, ausgebildet ist, wobei insbesondere die wenigstens eine Klammervorrichtung und das Positionierelement zur Positionierung in einem Spritzgießwerkzeug aus Kunststoff ausgebildet sind.

Das Trägerelement weist zweckmäßigerweise zwei Klammervorrichtungen auf, in welche insbesondere jeweils ein Gehäuse und/oder eine Haltevorrichtung des Sensorelements eingeclipst bzw. mit dieser befestigt wird.

Es ist bevorzugt, dass das Trägerelement Schmelzrippen aufweist, welche dem Positionierelement zugeordnet sind. Diese Schmelzrippen sind dabei insbesondere in das Positionierelement integriert.

Das Trägerelement umfasst zweckmäßigerweise einen Metallrahmen und eine mit diesem verbundene Trägervorrichtung, welche das Positionierelement und die mindestens eine Klammervorrichtung umfasst. Der Metallrahmen weist insbesondere ein oder mehrere Verbindungselement zu wenigstens einem weiteren Trägerelement bzw. zu dessen Metallrahmen auf. Der Metallrahmen wird zweckmäßigerweise vor dem gemeinsamen Umspritzen des Trägerelements und des Sensorelements entfernt. Insbesondere findet dieses Entfernen während oder nach einem Crimpvorgang statt, bei welchem Kontaktanschlüsse des Trägerelements jeweils mit zumindest einem Kontaktbein des Sensorelements und einem Kontaktierungselement eines externen Anschlusskabels oder eines externen Steckers, also beispielsweise mit einer entsprechenden Kabellitze oder einem Steckerpin/ -terminal, gemeinsam elektrisch leitend verbunden werden, also beispielsweise gecrimpt oder geschweißt oder gelötet oder geklebt.

Es ist zweckmäßig, dass die wenigstens eine Klammervorrichtung zwei biegsame Schenkel umfasst, welche eine Haltevorrichtung des Sensorelements durch einen Einclips- und/oder Einrastvorrang im Wesentlichen formschlüssig aufnehmen bzw. festhalten können. Die beiden Schenkel weisen dabei insbesondere an ihren Enden bzw. Köpfen jeweils eine Verrundung zur erleichterten Aufnahme der Haltevorrichtung des Sensorelements auf. Die Enden bzw. Köpfe wenigstens eines Schenkels weisen besonders bevorzugt einen Schlitz oder eine Nut zur Aufnahme einer entsprechend einpassbar ausgebildeten Haltevorrichtung des Sensorelements auf.

Die beiden Schenkel der wenigstens einen Klammervorrichtung umfassen zweckmäßigerweise jeweils eine Nut auf der Innenseite des Schenkels, insbesondere zur Aufnahme bzw. zum Einrasten jeweils einer Fixiernase oder Fixierkante der Haltevorrichtung des Sensorelements.

Das Trägerelement, insbesondere dessen Basiselement bzw. Leadframe, weist bevorzugt zumindest zwei elektrische Kontaktanschlüsse auf, welche "crimpfähig" und/oder korbförmig ausgebildet sind und jeweils wenigstens teilweise einen externen Anschlusskontakt, wie beispielsweise eine Kabellitze oder einen Steckerpin/ -terminal, und ein Kontaktbein bzw. Kontaktierungsbein des Sensorelements umgreifen können, wodurch eine mechanisch feste, elektrisch leitfähige Verbindung entsteht. Alternativ vorzugsweise sind die Kontaktanschlüsse des Trägerelements im Wesentlichen plan ausgebildet und mit jeweils einem Kontaktierungsbein des Sensorelements und einer Litze oder einem Steckerpin/ -terminal eines externen Anschlusses gemeinsam verschweißt.

Die Haltevorrichtung des Sensorelements und die Klammervorrichtung des Trägerelements sind vorzugsweise so ausgebildet, dass sie formschlüssig miteinander verbindbar sind und damit eine Befestigung des Sensorelements am Trägerelement ermöglichen.

Der Umspritzungsvorgang zur Ausbildung des Sensorgehäuses bzw. der gemeinsame Umspritzungsvorgang von Sensorelement und Trägerelement wird vorzugsweise als Overmold-Spritzgießvorgang durchgeführt.

Unter einem Overmold-Spritzgießvorgang wird bevorzugt ein Spritzgießvorgang verstanden, bei welchem ein Thermoplast in eine Außenform, beispielsweise eine kundenspezifische Außenform, insbesondere mittels eines Schneckentriebs gepresst wird. Besonders bevorzugt wird über eine Extruder-Schnecke ein zähflüssiges Moldmaterial, beispielsweise Polyamid, in die Spritzgießform bzw. Mold-Kavität gedrückt, wonach das thermoplastische Material durch Abkühlung an der Spritzgießformwand erstarrt. Danach wird das fertige Spritzgießbauteil dem Werkzeug entnommen.

Das Sensorelement wird vorzugsweise mit mindestens einer, insbesondere von außen umgreifbaren, Haltevorrichtung in wenigstens eine Klammervorrichtung des Trägerelements vor dem gemeinsamen Umspritzungsvorgang eingefügt und/oder eingeclipst und/oder eingepresst.

Das Trägerelement wird bevorzugt nach dem Verbinden mit dem Sensorelement mit wenigstens einem Positionierelement in einem Spritzgießwerkzeug positioniert und/oder befestigt.

Vor dem Verbinden mit dem Trägerelement wird das Sensorelement vorzugsweise hergestellt, indem zumindest Teile des Sensorelements während seiner Herstellung mindestens einem Plasmabehandlungsvorgang unterzogen werden.

Es können verschiedene Methoden der Generierung von Plasmen zur Plasmabehandlung verwendet werden, wie beispielsweise das Anlegen von hochfrequenten Wechselspannungen an ein Gas oder die diesbezügliche Verwendung von Gleichstrom und/oder die Anregung eines Gases mit Mikrowellen. Beispielhafte Gasgemische zur Plasmabehandlung enthalten Sauerstoff, Argon, Wasserstoff und/oder Stickstoff. Die Art des Gemischs hängt von den speziellen Anforderungen an den Plasmabehandlungsprozess ab, welche sich beispielsweise aus Art der Verunreinigung und dem behandelten Werkstoff ergeben. Abhängig von der Art des Gasgemischs wirkt das Plasma oxidierend oder reduzierend oder aktivierend. Oxidierende Plasmen sind zum Entfernen organischer Verunreinigungen geeignet, während reduzierende Plasmen auch für das Entfernen anorganischer Ablagerungen und/oder zum Abbau von Oxidablagerungen geeignet sind.

Der Plasmabehandlungsvorgang umfasst bevorzugt einen Plasmareinigungsvorgang und/oder einen Plasmaaktivierungsvorgang.

Unter einem Plasmareinigungsvorgang wird vorzugsweise ein trockenes, berührungsloses, chemisches und/oder physikalisches, nicht abrasives Reinigungsverfahren verstanden, mit dem höchste Reinigungsqualitäten erzielt werden können. Insbesondere organische Verunreinigungen werden durch chemische Reaktion mit freien Radikalen des Plasmas beispielsweise in Wasserdampf, Kohlendioxid und/oder CH₄ umgewandelt. Zum chemischen Entfernen von Kontamination enthält das Plasma beispielsweise Sauerstoff oder Wasserstoff oder Argon. Sauerstoff ist dabei zum Entfernen organischer Kontaminationen geeignet und Wasserstoff zum Entfernen anorganischer und/oder organischer Stoffe sowie zum Reduzieren von Oxiden. Der Reinigungsprozess ist zweckmäßigerweise eine Kombination aus einem physikalischen und einem chemischen Wirkprozess oder alternativ vorzugsweise ausschließlich ein chemischer Wirkprozess (ionenfrei).
Physikalisch: Verbindet man beispielsweise den zu reinigenden Gegenstand mit einer Kathode zur Plasmaerzeugung, werden aufgrund des angelegten elektrischen Feldes positive Ionen aus dem Plasma in dessen Richtung beschleunigt. Beim Auftreffen lösen diese Ionen durch direkten Impulsübertrag Atome und Moleküle von der Oberfläche ab.
Chemisch: Angeregter Sauerstoff und Sauerstoffionen bilden beispielsweise bei der Reaktion mit Kohlenwasserstoffen Kohlendioxid. Angeregter Wasserstoff bildet beispielsweise Halogenide, Sulfide, CHₓ, insbesondere CH₄, und Wasserdampf.

Unter einem Plasmaaktivierungsvorgang wird bevorzugt ein Plasmabehandlungsvorgang zur Erhöhung der Oberflächenspannung bzw. -haftung des zu behandelden bzw. aktivierenden Körpers verstanden. Dabei wird die Adhäsion zwischen einem Substrat bzw. dem Körper mit einem aufzutragenden Material, bspw. Moldmaterial verstärkt. Das Substrat bzw. dieser Körper ist somit leichter von einem, insbesondere flüssigen, Mittel oder Stoff zu benetzen bzw. haftend einzuhüllen. Der Kontaktwinkel eines Tropfens auf dem Körper ist dabei ein gängiges Maß für die Oberflächenspannung des Körpers. Ist die Oberfläche Körpers hydrophob (wasserabweisend) hat er eine geringe Oberflächenspannung. Mittels eines Plasmaaktivierungsvorgangs erreicht man wie mit einem Haftvermittler eine Erhöhung der Oberflächenspannung. Die Oberfläche des Körpers ist nach dem Plasmaaktivierungsvorgang hydrophil bzw. gut benetzbar, der Kontaktwinkel ist verringert und die Neigung zur Delamination ist geringer. Ein Plasmaaktivierungsvorgang wird beispielsweise zur Verbesserung der Haftung von Klebern oder Beschichtungen auf bestimmten Kunststoffen verwendet.

Das Verfahren umfasst zweckmäßigerweise einen Plasmareinigungsvorgang vor einem Kontaktierungsvorgang zur deutlichen Verminderung der Korrosionsanfälligkeit und einen Plasmaaktivierungsvorgang vor einem Umspritzungsvorgang zur deutlichen Verminderung der Delaminationsanfälligkeit.

Das Sensorelement wird vorzugsweise mit wenigstens einem Messfühlerelement und/oder zumindest einer elektronischen Schaltung bestückt, welche insbesondere auf dem Basiselement bzw. dem Leadframe direkt oder indirekt angeordnet werden, besonders bevorzugt auf einem Trägersockel bzw. auf eine Bondinsel/ ein "die-pad" des Basiselements. Das Messfühlerelement und/oder die elektrische Schaltung werden ganz besonders bevorzugt nach einem ball-stich-on-ball-Bondverfahren bzw. einem stich-on-bump-Bondverfahren (SOB) elektrisch kontaktiert, wodurch eine hohe Zug- und Scherfestigkeit der elektrischen Kontaktierungen erreicht werden kann. Alternativ werden das Messfühlerelement und/oder die elektrische Schaltung ganz besonders bevorzugt nach einem wedge-ball-Bondverfahren oder nach einem reverse-stich-on-ball-Bondverfahren (RSOB) elektrisch kontaktiert.

Das Sensorelement, insbesondere der Basiselement und optional weitere Bauteile des Sensorelements, werden vorzugsweise vor einem Bestückungsvorgang und/oder vor einem Kontaktierungsvorgang mit elektrischen Anschlussmitteln zumindest teilweise einem Plasmabehandlungsvorgang unterzogen, insbesondere einem Plasmareinigungsvorgang.

Es ist zweckmäßig, dass vor einem Umspritzungsvorgang zur Herstellung wenigstens des ersten Gehäuses des Sensorelements, zumindest Teile des Sensorelements einem Plasmabehandlungsvorgang, insbesondere einem Plasmaaktivierungsvorgang, unterzogen werden.

Vor zumindest einem Umspritzungsvorgang, insbesondere einem Kunststoffspritzgussvorgang, werden bevorzugt zumindest Teile des Sensorelements, besonders bevorzugt das erste und zweite Gehäuse, einem Plasmabehandlungsvorgang unterzogen, insbesondere einem Plasmaaktivierungsvorgang. Dies erfolgt ganz besonders bevorzugt nach mindestens einem Bestückungsvorgang.

Unter einem Messfühlerelement wird vorzugsweise ein Magnetoelektrisches-Wandlerelement, insbesondere ein AMR-, GMR-, oder ein anderes magnetoresistives Element oder ein Hall-Element, verstanden, welches besonders bevorzugt eine Brückenstruktur aufweist und auch als Brücken-die bezeichnet wird. Das Messfühlerelement weist zweckmäßigerweise kombinierte Magneto-elektrische-Wandlerelemente unterschiedlicher Wirkweise auf.

Das Basiselement bzw. der Leadframe wird bevorzugt beidseitig mit jeweils zumindest einem Bauelement bestückt.

Das Messfühlerelement und wenigstens ein Teil des Basiselements werden vorzugsweise umspritzt, wodurch das erste Gehäuse des Sensorelements ausgebildet wird. Zusätzlich wird zumindest ein Teil des Basiselements und insbesondere ein elektronisches Schutzelement, umspritzt, wodurch das zweite Gehäuse des Sensorelements ausgebildet wird. Das erste und zweite Gehäuse weisen dabei besonders bevorzugt einen definierten Abstand zueinander auf.

Während des Umspritzungsvorgangs zur Herstellung des Sensors bzw. zur Ausbildung des Sensorgehäuses werden zweckmäßigerweise das erste und das zweite Gehäuse des Sensorelements gemeinsam umspritzt.

Es ist bevorzugt, dass insbesondere am Ende des Herstellungsverfahrens des Sensorelements und/oder des Sensors, das Sensorelement oder der Sensor einem zusätzlichen Plasmabehandlungsvorgang unterzogen werden, insbesondere einem Plasmareinigungsvorgang, wodurch die freiliegenden Kontakte bzw. Anschlussmittel des Sensorelements bzw. des Sensors nicht oder nur in relativ geringem Maße korrodieren bzw. zu Korrosion neigen. Außerdem kann aufgrund des Plasmareinigungsvorgangs auf einen Galvanisierungsvorgang, beispielsweise ein Verzinnen oder Vernickeln, zum Schutz der freiliegenden Kontakte bzw. Anschlussmittel verzichtet werden. Das Sensorelement und/oder der Sensor werden anschließend besonders bevorzugt direkt luftdicht verpackt.

Das Verfahren zur Herstellung des Sensorelements umfasst vorzugsweise folgende Schritte:
Ausstanzen eines Basiselements aus einem Rohkörper, welcher insbesondere aus einem Metallblech ausgebildet ist oder Verwendung eines Trägerstreifens/ einer Trägerfolie oder ein MID-Elements also Basiselement. Anschließend werden eine Oberflächenbeschichtung und/oder wenigstens eine Kontaktstelle auf zumindest einer Seite des Basiselements aufgebracht. Im Anschluss erfolgt die Bestückung des Basiselements mit wenigstens einem elektronischen Bauelement.

Es ist bevorzugt, dass im Zuge der Bestückung des Basiselements des Sensorelements zunächst eine erste Seite bzw. eine erste Fläche des Basiselements mit einem ersten Klebemittel (dispense) versehen wird. Dieses erste Klebemittel ist wahlweise elektrisch leitfähig oder isolierend und weist eine relativ gute Wärmeleitfähigkeit auf. Danach wird auf diese erste Seite wenigstens eine elektronische Schaltung, auch als ASIC-die bezeichnet und/oder mindestens ein Messfühlerelement, welches besonders bevorzugt als Brücke ausgebildet ist, aufgebracht. Der ASIC-die dient ganz besonders bevorzugt als Montageträger für das Messfühlerelement. Dabei ist das Messfühlerelement beispielsweise mittels einer FlipChip-Montage auf dem ASIC-die angeordnet.

Das ASIC-die und das Messfühlerelement sind zweckmäßigerweise als ein integriertes Bauelement ausgebildet.

Bevorzugt wird danach das Klebemittel bzw. werden der Basiselement sowie die Bauelemente auf der ersten Seite des Leadframes erwärmt, wodurch die Verbindung mittels des ersten Klebemittels aushärtet.

Danach wird das Basiselement bzw. der Leadframe zweckmäßigerweise einem Plasmabehandlungsvorgang, insbesondere einem Plasmareinigungsvorgang, unterzogen, wodurch die Oberfläche des Basiselements und der Bauteile zumindest teilweise von korrosionsfördernden Sulfid-, Halogen- und/oder Kohlenstoff-Kontaminationen gereinigt werden. Zudem erfolgt eine Reduktion der Oxidschicht. Dies ist besonders vorteilhaft zur Gewährleistung von zuverlässigen elektrischen Kontaktierungen zwischen Bonddrähten und dem Leadframe bzw. dem Basiselement und/oder mit zumindest einer Kontaktstelle des ASIC-dies oder Messfühlerelements. Außerdem dient diese Reinigung zur Erreichung einer relativ hohen Dichtigkeit im Zuge einer zumindest teilweisen Umspritzung des Leadframes bzw. des Basiselements.

Nach dem Bestücken des Leadframes bzw. Basiselements bzw. eines entsprechenden Bestückungsvorgangs und insbesondere nach einem anschließenden Plasmabehandlungsvorgang, werden bevorzugt zumindest das ASIC-die und/oder das Messfühlerelement mittels eines Draht-Bondvorgangs elektrisch leitend miteinander und/oder mit dem Leadframe bzw. Basiselement verbunden. Dabei werden besonders bevorzugt zunächst an allen Kontaktstellen auf dem Basiselement und auf Kontaktierungspads bzw. auf Kontakierungsmitteln der entsprechenden Bauelemente in geeigneter Weise Bumps bzw. Lothügel aufgebracht. Danach werden die jeweiligen Bonddrähte gezogen, wobei dies nach dem sogenannten ball-stich-on-ball-Bondverfahren (BSOB) bzw. stich-on-bump-Bondverfahren (SOB) durchgeführt wird. Ganz besonders bevorzugt werden die Bonddrähte, welche einen Kontakt mit dem ASIC-die aufweisen, von den Kontaktierungspads des ASIC-die weg zu dem jeweiligen Zielpunkt und dem dortigen Bump der elektrischen Verbindung hingezogen. Durch diese Art des Bondvorgangs werden unerwünschte thermische und mechanische Beeinflussungen der Bauelemente relativ gering gehalten. Alternativ erfolgt die elektrische Kontaktierung des ASIC-die und/oder des Messfühlerelements mittels eines wedge-ball-Bondverfahrens oder eines reverse-stich-on-ball-Bondverfahrens.

Es ist zweckmäßig, dass im Zuge der Kontaktierung mindestens eines, insbesondere mehrere, der oben genannten Bondverfahren zur Kontaktierung verschiedener elektrischer Kontakte durchgeführt wird. Besonders bevorzugt werden die elektronischen Bauelemente mittels des stich-on-bump-Bondverfahrens (SOB) kontaktiert und das Basiselement bzw. der Leadframe mittels des wedge-ball-Bondverfahrens oder eines anderen Wedge-Bondverfahrens. Alternativ vorzugsweise werden sämtliche elektrische Kontaktierungen mittels des stich-on-bump-Bondverfahrens (SOB) bzw. (BSOB) durchgeführt.

Das Kontaktierungspad des ASIC-die ist zweckmäßigerweise zumindest teilweise aus Aluminium ausgebildet und/oder das Kontaktierungspad des Messfühlerelements aus Gold. Das Kontaktierungspad des ASIC-die aus Aluminium ist insbesondere als Metallisierung mit einer Dicke von weniger als 1µm ausgebildet.

Als Bonddraht wird bevorzugt Golddraht verwendet, welcher als Zusatzstoff Palladium aufweist bzw. mit geringen Mengen Palladium dotiert ist.

Die oben vorgeschlagenen Kontaktierungen ermöglichen eine hohe Temperaturbelastbarkeit, insbesondere für Temperaturen bis 180°C, beispielsweise zur Verwendung in Kraftfahrzeugen, sowie eine hohe Zug- und Scherfestigkeit.

Zweckmäßigerweise wird anschließend auf einer zweiten, der ersten Seite gegenüberliegenden, Seite des Basiselements bzw. Leadframes ein zweites Klebemittel aufgebracht. Danach wird auf der zweiten Seite ein magnetisches Mittel, insbesondere ein Ferrit, im Bereich gegenüber der Brücke so angeordnet, dass sich besonders bevorzugt der Massenschwerpunkt des Magneten senkrecht bezüglich des Basiselements im Wesentlichen über dem Massenschwerpunkt und/oder dem geometrischen Mittelpunkt der sensitiven Fläche des Messfühlerelements befindet. Ganz besonders bevorzugt wird zusätzlich ein elektronisches Schutzelement mit einem definierten Abstand zum ASIC-die wahlweise auf der ersten Seite oder der zweiten Seite des Basiselements angeordnet. Dieses Schutzelement wird zweckmäßigerweise auf derselben Bondinsel wie der ASIC-die oder alternativ vorzugsweise an einer anderen Stelle des Basiselements in einem definierten Abstand zum ASIC-die angebracht, insbesondere ist das Schutzelement dabei mit zwei Kontaktierungsbeinen des Basiselement mechanisch und elektrisch verbunden. Letzteres bietet den Vorteil, dass die mechanische Stabilität der Anschlusspins zum Moldgehäuse verbessert wird. Das Schutzelement wird dabei zweckmäßigerweise von dem zweiten Gehäuse umgeben.

Das zweite Klebemittel ist vorzugsweise elektrisch leitfähig ausgebildet.

Das erste und das zweite Klebemittel werden bevorzugt punktförmig oder als kreuzende Striche dosiert, in der Weise, dass nach dem Bestückungsvorgang bzw. "Die-Attach" die Ecken des jeweiligen Bauelements ausreichend mit Klebemittel bedeckt sind.

Anschließend wird das zweite Klebemittel zweckmäßigerweise ebenfalls durch Erwärmung ausgehärtet.

Das Erwärmen wird, insbesondere jeweils, zweckmäßigerweise in einem Ofen durchgeführt.

Das elektronische Schutzelement ist bevorzugt als Kondensator oder alternativ vorzugsweise als Doppel-Zehnerdiode oder Varistor ausgebildet. Die elektrische Kontaktgabe erfolgt über Klebeverbindung oder Drahtbondtechnik.

Die Herstellung des ersten und/oder zweiten Gehäuses des Sensorelements erfolgt vorzugsweise durch einen als Transfer-Molden bezeichneten Umspritzungsvorgang.

Unter Transfer-Molden wird bevorzugt ein Spritzgießvorgang verstanden, bei welchem ein festes und/oder vorgemischtes Moldmaterial unter einem erhöhten Druck und erhöhter Temperatur verflüssigt wird und anschließend in eine Spritzgussform, insbesondere unter erhöhtem Druck, geleitet wird, in welcher das Moldmaterial zu einem Duroplast-Körper erstarrt bzw. auskristallisiert, wobei dieser Duroplast-Körper im Wesentlichen nicht mehr schmelzbar ist.

Es ist zweckmäßig, dass nach der kompletten Bestückung des Basiselements des Sensorelements ein bzw. unmittelbar vor dem Transfer-Molden, ein zusätzlicher Plasmabehandlungsvorgang durchgeführt wird. Dieser zusätzliche Plasmabehandlungsvorgang umfasst insbesondere einen Plasmareinigungsvorgang und danach einen Plasmaaktivierungsvorgang. Der Plasmaaktivierungsvorgang betrifft dabei besonders bevorzugt die ASIC-die, Kleber- und Ferrit-Oberflächen, wodurch eine bessere Haftung des Moldmaterials bzw. Spritzgussmaterials ermöglicht wird. Durch diese Plasmabehandlungsvorgänge wird ganz besonders bevorzugt ein sonst üblicher, zusätzlicher Galvanisierungsvorgang eingespart.

Das ASIC-die, das Messfühlerelement, sowie das magnetische Mittel werden zweckmäßigerweise gemeinsam umspritzt, wodurch ein erstes Gehäuse um diese Bauelemente ausgebildet wird. Besonders bevorzugt wird zusätzlich das elektronische Schutzelement separat umspritzt, wodurch ein zusätzliches zweites Gehäuse ausgebildet ist. Als Umspritzungstechnik wird bevorzugt das Transfer-Molden angewandt.

Es ist bevorzugt, dass das Basiselement bzw. der Leadframe eines Sensorelements mit dem Basiselement/Leadframe anderer Sensorelemente über Verbindungsstege im Wesentlichen in Form einer Kette bzw. eines Streifens verbunden ist. Nach dem Umspritzungsvorgang werden die Basiselement, insbesondere durch einen Stanzvorgang, vereinzelt.

Es ist zweckmäßig, dass der Basiselement zumindest eine Bondinsel bzw. einen Trägersockel bzw. ein die-pad aufweist, auf welchem das ASIC-die und das Messfühlerelement auf der ersten Seite und das magnetische Mittel auf der zweiten Seite angeordnet sind. Außerdem weist das Basiselement mindestens zwei Kontaktierungsanschlüsse auf, welche zum Teil mit der Bondinsel verbunden sind.

Nach dem Umspritzen und insbesondere Vereinzeln der Basiselemente wird vorzugsweise das magnetische Mittel magnetisiert. Anschließend wird besonders bevorzugt der Leadframe mit Steckerterminals oder einem Kabel durch Crimpen und/oder Schweißen und/oder Löten und/oder Kleben elektrisch leitend verbunden, dabei werden ganz besonders bevorzugt die Kontaktierungsanschlüsse mit dem Stecker oder Kabel verbunden werden.

Das ASIC-die sowie das Messfühlerelement bzw. das Brücken-die weisen vorzugsweise im Wesentlichen die gleiche Höhe auf und ragen deshalb im Wesentlichen gleichweit von der ersten Seite des Basiselements ab. Dabei sind das ASIC-die und das Brücken-die um eine definierte Länge voneinander beabstandet auf der ersten Seite des Basiselements angeordnet. Es hat sich herausgestellt, dass diese Anordnung vorteilhaft für die gemeinsame Umspritzung ist. Die definierte Länge zwischen ASIC-die und Brücken-die bzw. dieser Abstand ist besonders bevorzugt größer als 40µm ausgebildet, um den Klebevorgang dieser Bauelemente sowie den anschließenden gemeinsamen Umspritzungsvorgang problemfrei zu ermöglichen.

Das Basiselement bzw. der Leadframe umfasst bevorzugt zwei oder mehr Kontaktierungsbeine, welche insbesondere durch das zweite Gehäuse miteinander verbunden sind und welche besonders bevorzugt teilweise aus dem dritten, gemeinsamen Gehäuse des Sensorelements als Kontaktelemente des Sensorelements herausragen.

Außerdem bezieht sich die Erfindung auf die Verwendung des Sensorelements und des Trägerelements in Kraftfahrzeugen, insbesondere als Geschwindigkeitssensor bzw. Geschwindigkeitssensoranordnung, besonders bevorzugt als Raddrehzahlsensor.

Das erfindungsgemäße Verfahren ist vorzugsweise zur Herstellung von Sensoren für sicherheitskritische Anwendungen vorgesehen. Insbesondere ist das Verfahren zur Herstellung von Geschwindigkeitssensoren, besonders bevorzugt für Kraftfahrzeuge, vorgesehen.

Weitere bevorzugte Ausführungsformen ergeben sich aus den Unteransprüchen und den nachfolgenden Beschreibungen von Ausführungsbeispielen an Hand von Figuren.

Es zeigen in schematischer Darstellung
- Fig. 1: ein Ausführungsbeispiel des Sensorelements, in einem Herstellungsstadium desselben, in dem das Sensorelement noch keine Haltevorrichtung aufweist,
- Fig. 2 und 3: beispielhafte Sensorelemente, welche jeweils eine Haltevorrichtung an einem ersten und zweiten Gehäuse zur Verbindung mit dem Trägerelement aufweisen,
- Fig. 4: ein beispielhaftes Ablaufdiagramm des Verfahrens zur Herstellung eines Sensors,
- Fig. 5: ein Ausführungsbeispiel eines Trägerelements mit zwei Klammervorrichtungen und einem Positionierelement mit integrierten Schmelzrippen, und
- Fig. 6: das beispielhafte Verbinden bzw. Einclipsen zwischen einem Sensorelement und einem Trägerelement.

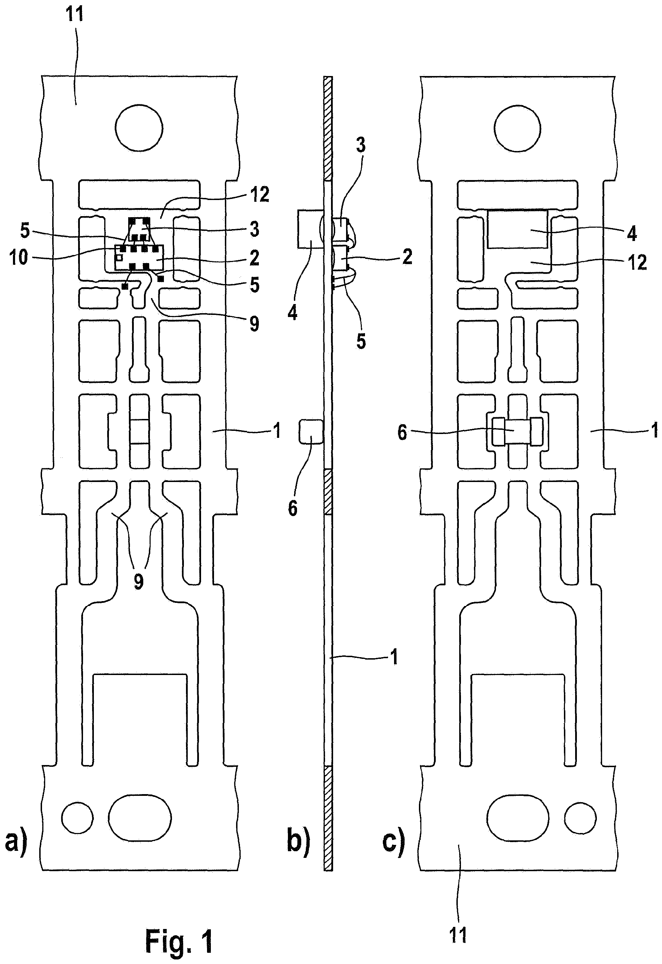

In Fig. 1 ist ein beispielhaftes Sensorelement innerhalb eines Herstellungsstadiums dargestellt, in welchem das Sensorelement noch keine Haltevorrichtung zur Verbindung mit einem Trägerelement aufweist. Dabei zeigt Fig. 1 a) eine Draufsicht auf die erste Seite des Basiselements 1, Fig. 1 b) eine Seitenansicht sowie Fig. 1 c) eine Draufsicht auf die zweite Seite bzw. die Unterseite des Basiselements 1. Basiselement 1 ist beispielgemäß als Leadframe aus Metall ausgebildet.

Die erste Seite Basiselements 1 ist mit einem Messfühlerelement 3 und einem ASIC-die 2 bestückt, welche durch elektrische Anschlussmittel 5 bzw. Bonddrähte, auch "wire bonds" genannt, miteinander und mit den Kontaktierungsbeinen 9 des Basiselements 1 verbunden sind. Das Messfühlerelement 3 und das ASIC-die 2 ragen im Wesentlichen gleich weit von Basiselement 1 ab bzw. sind gleich hoch ausgebildet. Die Verdrahtung bzw. elektrische Kontaktierung ist beispielgemäß entsprechend einem ball-stich-on-ball-Bondverfahren ausgebildet, wobei die AU-Drähte 5 mit Bondhügeln bzw. Bumps bzw. Gold-Bumps verbunden sind, die auf den Kontaktierungsbeinen 9 des Basiselements 1 und auf Kontaktierungspads 10 des Messfühlerelements 3 und des ASIC-dies 2 angeordnet sind. Bei dem in Fig. 1 dargestellten Ausführungsbeispiel ist das dargestellte Sensorelement bezüglich seines Basiselements mittels eines Bands 11 oder einer anderen Verbindung mit weiteren, nicht dargestellten, Basiselement verbunden. Messfühlerelement 3 und ASIC-die 2 sind auf einem Trägersockel 12 des Basiselements 1 angeordnet.

Der Trägersockel 12 bzw. die Bondinsel ist auf der zweiten Seite des Basiselements 1 mit einem magnetischen Mittel 4, welches als Ferrit ausgebildet ist, bestückt. Außerdem ist die zweite Seite des Basiselements 1 mit einem elektronischen Schutzelement 6, beispielgemäß als Kondensatorelement ausgebildet, bestückt, welches in einem definierten Abstand zu Trägersockel 12 bzw. zu ASIC-die 2 angeordnet ist.

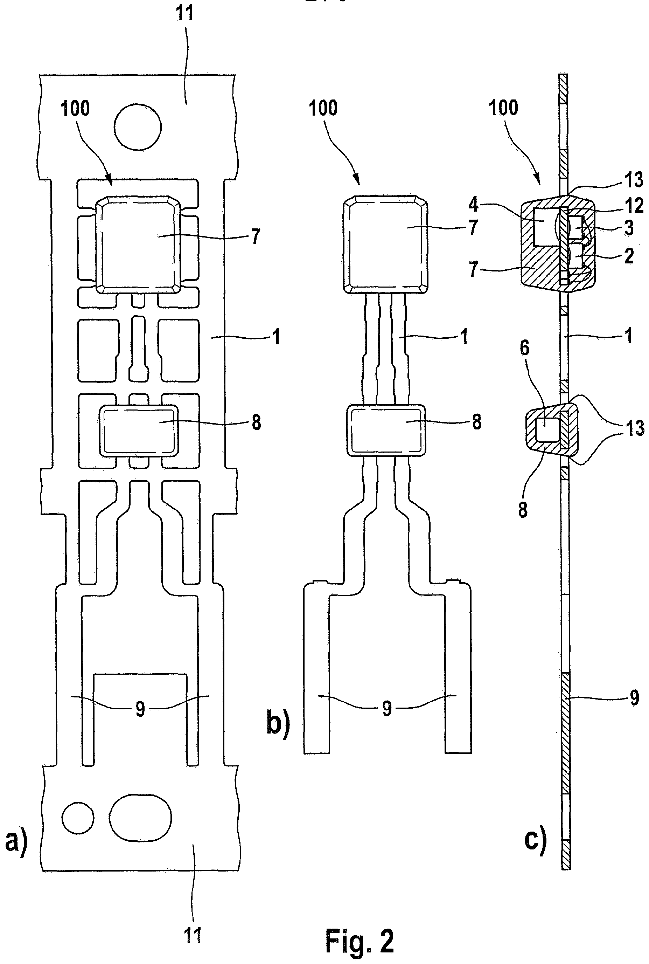

Fig. 2 zeigt ein Ausführungsbeispiel eines Sensorelements 100 mit einem ersten und einem zweiten Gehäuse 7, 8, welche in einem Spritzgussverfahren aus einem duroplastischen Mold-Compound, beispielsweise aus Epoxy, ausgebildet sind. In Fig. 2 a) ist Sensorelement 100 noch bezüglich seines Basiselements 1 durch Band 11 mit weiteren, nicht dargestellten, Sensorelementen verbunden. Basiselement 1 weist dabei zwei Kontaktierungsbeine 9 und einen Trägersockel auf, wobei dieser Trägersockel durch das erste Gehäuse 7 umhüllt ist. Fig. 2 b) zeigt das beispielhafte Sensorelement 100 nach einem Vereinzelungsprozess, in dem nur der Teil des Basiselements 1 ausgestanzt und weiterverarbeitet wird, der für das fertige Sensorelement relevant ist. Fig. 2 c) zeigt eine seitliche Schnittansicht dieses beispielgemäßen Sensorelements 100. Aus dieser Ansicht sind Haltevorrichtungen 13, die Teil des ersten und zweiten Gehäuses 7, 8 sind, erkennbar. Haltevorrichtungen 13 sind beispielgemäß jeweils als abgerundete, von außen umgreifbare Kante des ersten und zweiten Gehäuses 7, 8 ausgebildet. Dabei enthält erstes Gehäuse 7 einen ASIC-die 2 und ein Messfühlerelement 3, angeordnet auf einer ersten Seite des Trägersockels 12 des Basiselements 1 sowie ein magnetisches Mittel 4 bzw. beispielgemäß einen Ferrit, angeordnet auf der zweiten Seite dieses Trägersockels 12. Das zweite Gehäuse 8 umfasst ein Kondensatorelement als elektronisches Schutzelement 6, welches mit den beiden Kontaktierungsbeinen 9 verbunden ist.

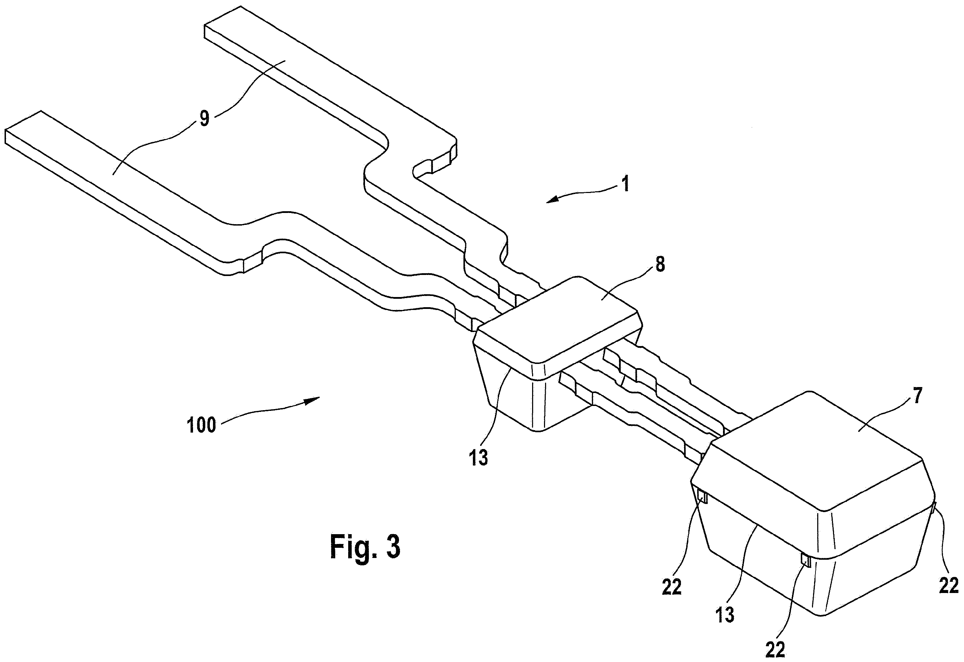

Fig. 3 veranschaulicht ein beispielhaftes Sensorelement 100 umfassend einen Basiselement 1 mit Kontaktierungsbeinen 9 und ein erstes 7 und zweites 8 Gehäuse aus Spitzguss. Das erste Gehäuse 7 umfasst ein nicht dargestelltes Messfühlerelement, einen ASIC-die sowie ein magnetisches Mittel. Das zweite Gehäuse 8 umfasst beispielhaft ein elektronisches Schutzelement oder ist in einem alternativen Ausführungsbeispiel "leer", besteht also nur aus dem umspritzten Teil des Basiselements und der Spritzgussmasse selbst. Dieses zweite Gehäuse 8 dient dabei außerdem einer mechanischen Entlastung, insbesondere einer Zugentlastung, bezüglich der Kontaktierungsbeine 9. Außerdem zeigt Fig. 3 die von außen umgreifbaren Haltevorrichtungen 13, beispielgemäß als abgerundete Kante ausgebildet, des ersten und zweiten Gehäuses. Die Haltevorrichtung 13 des ersten Gehäuses 7 umfasst auf zwei gegenüberliegenden Seiten außerdem jeweils zwei Fixiernasen 22.

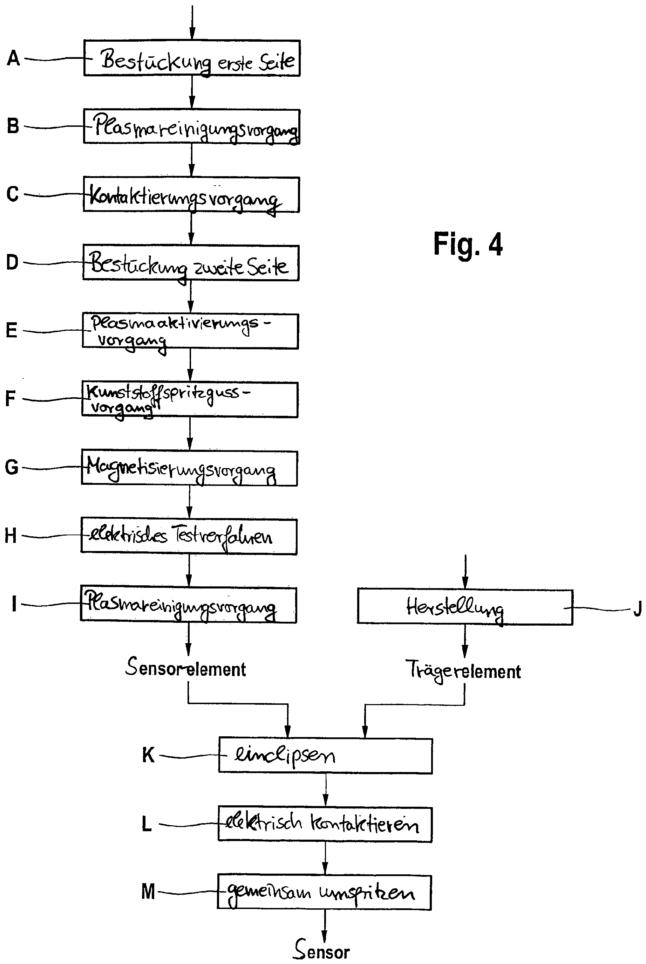

Anhand der Fig. 4 ist ein beispielhaftes Verfahren zur Herstellung eines Sensors in einem Flussdiagramm veranschaulicht. Dabei betreffen Verfahrensschritte A bis I die Herstellung eines beispielhaften Sensorelements, der Verfahrensschritt J die Herstellung eines beispielhaften Trägerelement und die Schritte K und L die Herstellung des Sensors.

Dabei wird der Basiselement bzw. Leadframe in einem Verfahrensschritt A "assemble 1st side" von einer ersten Seite bestückt. In diesem Verfahrensschritt A wird auf einen Teil der ersten Seite des Basiselements, beispielgemäß auf die erste Seite eines Trägersockels, ein erstes, elektrisch isolierendes und relativ gut wärmeleitfähiges Klebemittel aufgebracht, was auch als "adhesive dispensing" bezeichnet wird. Danach wird ein ASIC-die und ein Messfühlerelement auf dieser ersten Seite angeordnet bzw. angeklebt, was auch als "die attach" bezeichnet werden kann. Danach wird das erste Klebemittel in einem Ofen ausgehärtet, "curing".

Anschließend wird ein Plasmareinigungsvorgang, "plasma cleaning", in Verfahrensschritt B durchgeführt. Dies dient der Vorbereitung eines elektrischen Kontaktierungsverfahrens.

Danach erfolgt ein Kontaktierungsvorgang C, "wire bonding", der auf der ersten Seite des Basiselements angeordneten Bauelemente bzw. des Messfühlerelements und des ASIC-dies, beispielgemäß nach einem ball-stich-on-ball-Bondverfahren mit AU-Draht.

Anschließend erfolgt ein Bestückungsvorgang D der zweiten Seite des Basiselements, "assemble 2nd side". Dabei wird beispielhaft ein Teil der zweiten Seite des Basiselements mit einem zweiten Klebemittel, das elektrisch leitfähig ist, benetzt, "adhesive dispensing", wonach ein magnetisches Mittel und ein elektronisches Schutzelement zur Verbesserung der EMV-Eigenschaften des Sensorelements auf der zweiten Seite, voneinander beabstandet angeordnet werden. Anschließend wird das zweite Klebemittel in einem Ofen ausgehärtet, "curing".

Nach den Bestückungsvorgängen wird ein Plasmaaktivierungsvorgang E, "plasma activation", durchgeführt bzw. der Sensorelements wird diesem Plasmaaktivierungsvorgang unterzogen.

Anschließend werden in einem Kunststoffspritzgussvorgang F, "transfer molding", ein erstes und ein zweites Gehäuse ausgebildet, welche die zuvor auf dem Basiselement angeordneten Bauelemente umfassen und die jeweils eine von außen umgreifbare, abgerundete Kante als Haltevorrichtung aufweisen. Der Spritzguss der Gehäuse wird in einem Ofen ausgehärtet, "post mold curing".

Danach erfolgt ein Magnetisierungsvorgang G des magnetischen Mittels, wonach ein elektrisches Testverfahren H, "electrical testing", des Sensorelements durchgeführt wird, bei dem die Funktionsfähigkeit des Messfühlerelements im Zusammenwirken mit dem magnetischen Mittel und die Funktionsfähigkeit des ASIC-dies geprüft wird.

Anschließend wird das Sensorelement einem Plasmareinigungsvorgang I "plasma cleaning" unterzogen, der die Korrosionsanfälligkeit des Sensorelements bzw. der freiliegenden elektrischen Kontakte des Sensorelements vermindert. Hierdurch braucht kein zusätzlicher Galvanisierungsvorgang, beispielsweise ein Verzinnen oder Vernickeln der freiliegenden elektrischen Kontakte, durchgeführt werden.

Alternativ erfolgt gar keine zusätzliche Behandlung des Sensorelements zum Schutz vor Korrosion sondern eine geeignete Verpackung, beispielsweise mittels einer luftdichten Verpackung bzw. mittels eines luftdichten Beutels, des Sensorelements.

In Verfahrensschritt J wird ein beispielhaftes Trägerelement "carrier element", welches an einem Metallrahmen befestigt ist, in einem Spritzgießvorgang hergestellt. Dabei werden ein Positionierelement und zwei Klammervorrichtungen ausgebildet.

Danach werden das Sensorelement und das Trägerelement in einem gemeinsamen Verfahrensschritt K "clipsing" miteinander mechanisch verbunden, indem das erste und zweite Gehäuse des Sensorelements mit ihren Haltevorrichtungen in die Klammervorrichtungen des Trägerelements formschlüssig eingeclipst werden.

Im Anschluss daran werden in einem gemeinsamen Verfahrensschritt L das Sensorelement und das Trägerelement sowie externe Anschlüsse gemeinsam elektrisch miteinander verbunden bzw. kontaktiert "connecting the elements". Dabei wird jeweils ein Kontaktierungsbein des Sensorelements sowie eine Kabellitze oder ein Steckerpin/ -terminal eines externen Anschlusses von einem, beispielhaft korbartig ausgebildetem, Kontaktanschluss des Trägerelements aufgenommen und mit diesem gemeinsam vercrimpt.

Anschließend werden die miteinander verbundenen Elemente, also das Sensorelement und das Trägerelement, in Verfahrensschritt M gemeinsam umspritzt. Dabei werden die verbundenen Elemente mittels des Positionierelements des Trägerelements in ein Spritzgießwerkzeug eingelegt bzw. in diesem Positioniert, wonach ein gemeinsamer Spritzgießvorgang "over molding" zur Ausbildung des Sensorgehäuses durchgeführt wird, bei dem beispielsweise das erste und das zweite Gehäuse des Sensorelements gemeinsam mit dem Trägerelement mittels eines Overmold-Spritzgießvorgangs umspritzt werden.

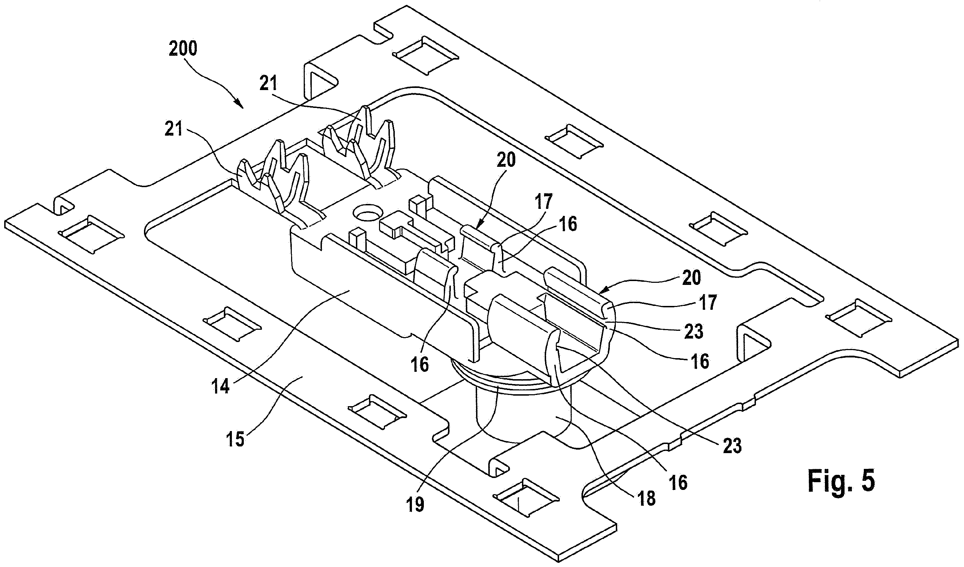

In Fig. 5 ist ein Ausführungsbeispiel eines Trägerelements 200 veranschaulicht, welches einen Metallrahmen 15 und eine Trägervorrichtung 14 umfasst. Trägervorrichtung 14 weist ein Positionierelement 18 mit integrierten Schmelzrippen 19 auf sowie zwei Klammervorrichtungen 20, welche jeweils zwei biegsame Schenkel 16 mit Verrundungen 17 an dessen Enden bzw. Köpfen aufweisen. Durch diese Verrundungen kann eine Haltevorrichtung des Sensorelements relativ leicht und präzise durch die Klammervorrichtung 20 aufgenommen bzw. in diese eingeclipst werden. Die untere, größere Klammervorrichtung weist außerdem auf der Innenseite der biegsamen Schenkel 16 jeweils eine Nut 23 auf. Das Trägerelement 200 weist außerdem zwei korbförmige Kontaktanschlüsse 21 aus Metall zur elektrischen Kontaktierung mit jeweils einem Kontaktierungsbein des Sensorelements und einer Kabellitze bzw. einem Steckpin oder einem anderem Anschlussmittel eines externen elektrischen Anschlusses auf.

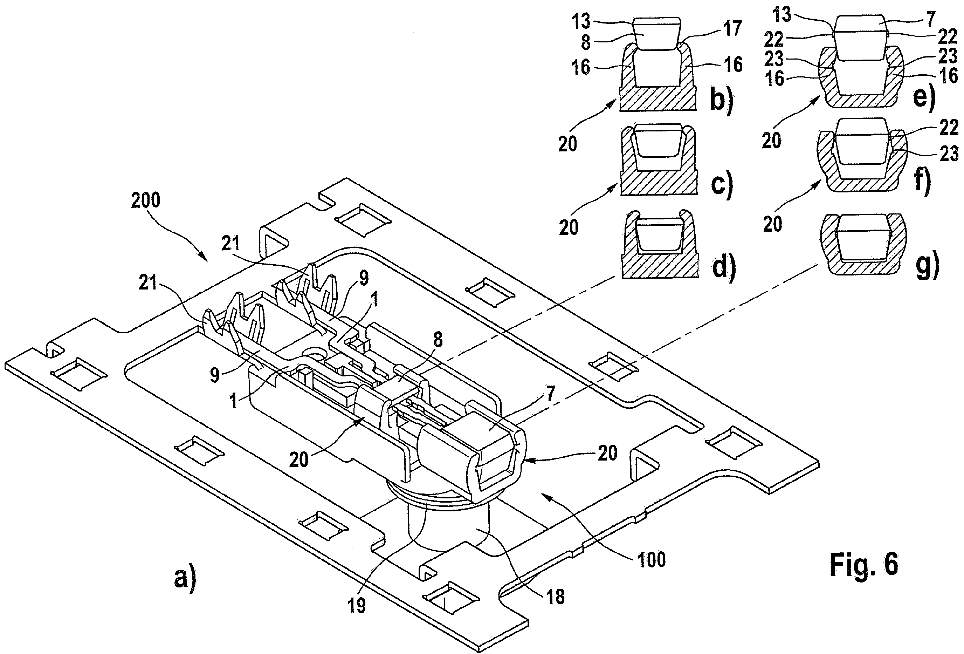

Fig. 6 zeigt eine beispielhafte Verbindung zwischen einem Sensorelement 100 und einem Trägerelement 200. Dabei ist in Fig. 6 a) eine beispielhafte Anordnung beider Elemente 100, 200 in bereits mechanisch verbundenem Zustand dargestellt. Anhand der Fig. 6 b) bis d) wird in drei Schritten das Einclipsen der Haltevorrichtung 13 des zweiten Gehäuses 8 in eine Klammervorrichtung 20 des Trägerelements, mit zwei biegsamen Schenkeln 16 veranschaulicht. Die beiden Schenkel 16 weisen an ihren Enden jeweils Verrundungen 17 auf. Fig. 6e) bis g) zeigen entsprechend beispielhaft eine Aufnahme bzw. das Einclipsen des erstens Gehäuses 7 des Sensorelements 100 in Klammervorrichtung 20. Dabei weist Haltevorrichtung 13 des ersten Gehäuses 7 eine abgerundete Kante und auf zwei gegenüberliegenden Seiten jeweils zwei Fixiernasen 22 zur präzisen Positionierung auf. Diese Fixiernasen 22 tauchen bzw. rasten dabei in jeweils eine Nut 23 auf der Innenseite der biegsamen Schenkel 16 der Klammervorrichtung 20 ein.

Die in Fig. 6 a) dargestellt Anordnung zeigt Sensorelement 100 mit Trägerelement 200 verbunden. Dabei sind erstes und zweites Gehäuse 7, 8 des Sensorelements mit einer jeweiligen Haltevorrichtung in Klammervorrichtungen 20 des Trägerelements eingeclipst. Kontaktierungsbeine 9 des Basiselements 1 des Sensorelements sind durch korbförmige Kontaktanschlüsse 21 des Trägerelements aufgenommen. Trägerelement 200 weist außerdem Positionierelement 18 mit integrierten Schmelzrippen 19 zur Positionierung der Anordnung in einem nicht dargestellten Spritzgießwerkzeug auf.

## Patentansprüche

1. Sensor, umfassend ein Sensorelement (100), welches wenigstens ein Messfühlerelement (3) umfasst, wobei das Sensorelement (100) eine Haltevorrichtung (13) zur Verbindung mit einem Trägerelement (200) aufweist, wobei die Haltevorrichtung (13) Teil eines ersten Gehäuses (7) ist und mit diesem einstückig verbunden ist und die Haltevorrichtung (13) wenigstens eine umgreifbare Kante aufweist, wobei der Sensor außerdem ein Trägerelement aufweist, umfassend wenigstens ein Positionierelement (18) zur Positionierung des Trägerelements in einem Spritzgießwerkzeug, wobei das Trägerelement (200) zumindest eine Klammervorrichtung (20) umfasst, welche eine Haltevorrichtung (13) des Sensorelements (100) aufnehmen und/oder festhalten kann, wobei
das Sensorelement (100) mit der von außen umgreifbaren, Haltevorrichtung (13) in die Klammervorrichtung (20) des Trägerelements (200) eingeclipst ist und wobei das Sensorelement und das Trägerelement von einem Sensorgehäuses zumindest teilweise umspritzt sind, wobei das Sensorgehäuse in einem gemeinsamen Umspritzungsvorgang (M) ausgebildet ist.

2. Sensor nach Anspruch 1, wobei die Haltevorrichtung (13) des Sensorelements von außen umgreifbar ausgebildet ist.

3. Sensor nach Anspruch 1 oder 2, wobei das erste Gehäuse (7) des Sensorelements direkt oder indirekt mit einem Basiselement (1), welches insbesondere als Leadframe ausgebildet ist, verbunden ist.

4. Sensor nach mindestens einem der Ansprüche 1 bis 3, wobei das erste Gehäuse (7) des Sensorelements wenigstens das Messfühlerelement (3) und/oder eine elektronische Signalverarbeitungsschaltung (2) umfasst.

5. Sensor nach mindestens einem der Ansprüche 2 bis 4, wobei das Sensorelement zusätzlich ein zweites Gehäuse (8) aufweist, welches ebenfalls eine von außen umgreifbare Haltevorrichtung (13) umfasst.

6. Sensor einem der vorhergehenden Ansprüche, wobei das Trägerelement zumindest teilweise aus Kunststoff ausgebildet ist, wobei insbesondere die wenigstens eine Klammervorrichtung (20) und das Positionierelement (18) aus Kunststoff ausgebildet sind.

7. Sensor einem der vorhergehenden Ansprüche, wobei das Trägerelement zwei Klammervorrichtungen (20) aufweist.

8. Sensor einem der vorhergehenden Ansprüche, wobei das Trägerelement so ausgebildet ist, dass die wenigstens eine Klammervorrichtung (20) zwei biegsame Schenkel (16) umfasst, welche eine Haltevorrichtung (13) des Sensorelements (100) durch einen Einclips- und/oder Einrastvorrang im Wesentlichen formschlüssig aufnehmen und/oder festhalten können, wobei diese beiden Schenkel (16) insbesondere an ihren Enden jeweils eine Verrundung (17) zur erleichterten Aufnahme der Haltevorrichtung (13) des Sensorelements aufweisen.

9. Verfahren zur Herstellung eines Sensors, bei dem ein Sensorelement (100), das wenigstens ein erstes Gehäuse (7) umfasst, in einem Umspritzungsvorgang zumindest teilweise umspritzt wird, wodurch ein Sensorgehäuse ausgebildet wird, wobei das Sensorelement (100) mit einem Trägerelement (200) mechanisch verbunden wird, wonach das Sensorelement und das Trägerelement in einem gemeinsamen Umspritzungsvorgang (M) zur Ausbildung des Sensorgehäuses zumindest teilweise umspritzt werden, **dadurch gekennzeichnet, dass**
das Sensorelement (100) mit mindestens einer von außen umgreifbaren, Haltevorrichtung (13) in wenigstens eine Klammervorrichtung (20) des Trägerelements (200) vor dem gemeinsamen Umspritzungsvorgang (M) eingeclipst wird.

10. Verfahren nach Anspruch 9, wobei das Trägerelement (200), nach dem Verbinden mit dem Sensorelement (100), mit wenigstens einem Positionierelement (18) in einem Spritzgießwerkwerk positioniert wird.

11. Verfahren nach Anspruch 9 oder 10, wobei das Sensorelement (100) vor dem Verbinden mit dem Trägerelement (200) hergestellt wird, indem zumindest Teile des Sensorelements während seiner Herstellung zumindest einem Plasmabehandlungsvorgang (B, E, I) unterzogen werden.

12. Verfahren nach Anspruch 11, wobei das Sensorelement (100), insbesondere wenigstens ein Basiselement (1) des Sensorelements, vor einem Bestückungsvorgang (A, D) mit Bauelementen (2, 3, 4, 6) und/oder vor einem Kontaktierungsvorgang (C) mit elektrischen Anschlussmitteln (5) zumindest teilweise einem Plasmabehandlungsvorgang (B), insbesondere einem Plasmareinigungsvorgang, unterzogen wird.

13. Verfahren nach Anspruch 11 oder 12, wobei vor einem Umspritzungsvorgang (F) zur Herstellung wenigstens eines ersten Gehäuses (7) des Sensorelements (100), zumindest Teile des Sensorelements einem Plasmabehandlungsvorgang (E) unterzogen werden, insbesondere einem Plasmaaktivierungsvorgang.

14. Verfahren nach mindestens einem der Ansprüche 11 bis 13, wobei das Sensorelement (100) mit wenigstens einem Messfühlerelement (3) und/oder zumindest einer elektronischen Schaltung (2) bestückt wird, welche insbesondere auf dem Basiselement (1) direkt oder indirekt angeordnet werden.

## Claims

1. Sensor, comprising a sensor element (100) which comprises at least one probe element (3), wherein the sensor element (100) has a holding device (13) for connection to a support element (200), wherein the holding device (13) is part of a first housing (7) and is integrally connected to it and the holding device (13) has at least one embraceable edge, wherein the sensor additionally has a support element, comprising at least one positioning element (18) for positioning the support element in an injection molding tool, wherein the support element (200) comprises at least one clamping device (20) which can accommodate and/or hold a holding device (13) of the sensor element (100), wherein the sensor element (100) is clipped, with the holding device (13) which is embraceable from the outside into the clamping device (20) of the support element (200), and wherein the sensor element and the support element are at least partially encapsulation molded with a sensor housing, wherein the sensor housing is formed in a common encapsulation molding process (M).

2. Sensor according to Claim 1, wherein the holding device (13) of the sensor element is formed so as to be embraceable from the outside.

3. Sensor according to Claim 1 or 2, wherein the first housing (7) of the sensor element is connected directly or indirectly to a basic element (1) which, in particular, is formed as lead frame.

4. Sensor according to at least one of Claims 1 to 3, wherein the first housing (7) of the sensor element comprises at least the probe element (3) and/or an electronic signal processing circuit (2).

5. Sensor according to at least one of Claims 2 to 4, wherein the sensor element additionally has a second housing (8) which likewise comprises a holding device (13) which is embraceable from the outside.

6. Sensor according to one of the preceding claims, wherein the support element is formed at least partially from plastic, the at least one clamping device (20) and the positioning element (18) being formed from plastic, in particular.

7. Sensor according to one of the preceding claims, wherein the support element has two clamping devices (20).

8. Sensor according to one of the preceding claims, wherein the support element is formed so that the at least one clamping device (20) comprises two flexible legs (16) which can accommodate and/or hold a holding device (13) of the sensor element (100) essentially positively by means of a clipping-in and/or locking-in process, these two legs (16) having especially at their ends in each case a rounded portion (17) for easier accommodation of the holding device (13) of the sensor element.

9. Method for manufacturing a sensor in which a sensor element (100), which comprises at least a first housing (7), is at least partially encapsulation molded in an encapsulation molding process, as a result of which a sensor housing is formed, wherein the sensor element (100) is mechanically connected to a support element (200), after which the sensor element and the support element are at least partially encapsulation molded in a common encapsulation molding process (M) for forming the sensor housing, **characterized in that** the sensor element (100) is clipped into at least one clamping device (20) of the support element (200) by means of at least one holding device (13) which can be embraced from the outside, before the common encapsulation molding process (M).

10. Method according to Claim 9, wherein the support element (200) is positioned in an injection molding tool by means of at least one positioning element (18) after being connected to the sensor element (100).

11. Method according to Claim 9 or 10, wherein, before being connected to the support element (200), the sensor element (100) is manufactured by at least parts of the sensor element being subjected to at least one plasma treatment process (B, E, I) during manufacture of said sensor element.

12. Method according to Claim 11, wherein the sensor element (100), especially at least one basic element (1) of the sensor element, is subjected at least partially to a plasma treatment process (B), especially a plasma cleaning process, before an assembly process (A, D) with components (2, 3, 4, 6) and/or before a contacting process (C) with electrical connecting means (5).

13. Method according to Claim 11 or 12, wherein, before an encapsulation molding process (F) for manufacturing at least a first housing (7) of the sensor element (100), at least parts of the sensor element are subjected to a plasma treatment process (E), especially a plasma activation process.

14. Method according to at least one of Claims 11 to 13, wherein the sensor element (100) is fitted with at least one probe element (3) and/or at least one electronic circuit (2) which, in particular, are arranged directly or indirectly on the basic element (1).

## Revendications

1. Capteur, comprenant un élément capteur (100), qui comprend au moins un élément de détection (3), dans lequel l'élément capteur (100) comporte un dispositif de maintien (13) pouvant être relié à un élément de support (200), dans lequel le dispositif de maintien (13) fait partie d'un premier boîtier (7) et est relié à celui-ci de manière solidaire et le dispositif de maintien (13) comporte au moins un bord pouvant être saisi, dans lequel le capteur comporte en outre un élément de support, comprenant au moins un élément de positionnement (18) destiné au positionnement de l'élément de support dans un outil de moulage par injection, dans lequel l'élément de support (200) comprend au moins un dispositif d'agrafage (20) qui peut recevoir et/ou retenir un dispositif de maintien (13) de l'élément capteur (100),
dans lequel l'élément capteur (100) est encliqueté dans le dispositif d'agrafage (20) de l'élément de support (200) à l'aide du dispositif de maintien (13) pouvant être saisi de l'extérieur, et dans lequel l'élément capteur et l'élément de support sont au moins partiellement enrobés par un boîtier de capteur, dans lequel le boîtier de capteur est réalisé par un processus d'enrobage commun (M).

2. Capteur selon la revendication 1, dans lequel le dispositif de maintien (13) de l'élément capteur est réalisé de manière à pouvoir être saisi de l'extérieur.

3. Capteur selon la revendication 1 ou 2, dans lequel le premier boîtier (7) de l'élément capteur est relié directement ou indirectement à un élément de base (1), qui est notamment réalisé sous la forme d'une grille de connexion.

4. Capteur selon au moins l'une des revendications 1 à 3, dans lequel le premier boîtier (7) de l'élément capteur comprend au moins l'élément de détection (3) et/ou un circuit de traitement du signal électronique (2).

5. Capteur selon au moins l'une des revendications 2 à 4, dans lequel l'élément capteur comporte en outre un second boîtier (8) qui comprend également un dispositif de maintien (13) pouvant être saisi de l'extérieur.

6. Capteur selon l'une quelconque des revendications précédentes, dans lequel l'élément de support est réalisé au moins partiellement en matière plastique, dans lequel l'au moins un dispositif d'agrafage (20) et l'élément de positionnement (18) sont notamment réalisés en matière plastique.

7. Capteur selon l'une quelconque des revendications précédentes, dans lequel l'élément de support comporte deux dispositifs d'agrafage (20).

8. Capteur selon l'une quelconque des revendications précédentes, dans lequel l'élément de support est réalisé de manière à ce que l'au moins un dispositif d'agrafage (20) comprenne deux branches flexibles (16) qui peuvent recevoir et/ou retenir sensiblement par complémentarité de forme un dispositif de maintien (13) de l'élément capteur (100) au moyen d'une protubérance de clipsage et/ou d'encliquetage, dans lequel lesdites deux branches (16) présentent notamment à leurs extrémités respectives un arrondi (17) permettant de faciliter la réception du dispositif de maintien (13) de l'élément capteur.

9. Procédé de fabrication d'un capteur, dans lequel un élément capteur (100) comprenant au moins un premier boîtier (7) est au moins partiellement enrobé lors d'un processus d'enrobage pour ainsi former un boîtier de capteur, dans lequel l'élément capteur (100) est mécaniquement relié à un élément de support (200), puis l'élément capteur et l'élément de support sont au moins partiellement enrobés lors d'un processus d'enrobage commun (M) destiné à réaliser le boîtier de capteur,
**caractérisé en ce que** l'élément capteur (100) est encliqueté avant le processus d'enrobage commun (M), à l'aide d'au moins un dispositif de maintien (13) pouvant être saisi de l'extérieur, dans au moins un dispositif d'agrafage (20) de l'élément de support (200).

10. Procédé selon la revendication 9, dans lequel l'élément de support (200), après la liaison à l'élément capteur (100), est positionné à l'aide d'au moins un élément de positionnement (18) dans un outil de moulage par injection.

11. Procédé selon la revendication 9 ou 10, dans lequel l'élément capteur (100) est fabriqué avant la liaison à l'élément de support (200) en soumettant au moins certaines parties de l'élément capteur, pendant sa fabrication, à au moins un processus de traitement au plasma (B, E, I).

12. Procédé selon la revendication 11, dans lequel l'élément capteur (100), notamment au moins un élément de base (1) de l'élément capteur, est soumis au moins partiellement, avant un processus d'implantation (A, D) de composants (2, 3, 4, 6) et/ou avant un processus de mise en contact (C) avec des moyens de raccordement électriques (5), à un processus de traitement au plasma (B), notamment un processus de nettoyage au plasma.

13. Procédé selon la revendication 11 ou 12, dans lequel, avant un processus d'enrobage (F) destiné à la fabrication d'au moins un premier boîtier (7) de l'élément capteur (100), au moins certaines parties de l'élément capteur sont soumises à un processus de traitement au plasma (E), notamment un processus d'activation au plasma.

14. Procédé selon au moins l'une des revendications 11 à 13, dans lequel au moins un élément de détection (3) et/ou au moins un circuit électronique (2), qui sont notamment disposés directement ou indirectement sur l'élément de base (1), est/sont implanté(s) sur l'élément capteur (100).
